# EUROPEAN PATENT APPLICATION

(11) **EP 4 773 177 A1**
(43) Date of publication of application: **08.07.2026**
(21) Application number: 24876348.4
(22) Date of filing: 14.09.2024
(51) Int. Cl.: H01L 21/68

(54) **POSITION CALIBRATION APPARATUS AND SEMICONDUCTOR PROCESS DEVICE**

(30) Priority: 09.10.2023 CN 202311302649
(71) Applicant: Beijing NAURA Microelectronics Equipment Co., Ltd., Beijing 100176 (CN)
(72) Inventor: LIU, Huan, Beijing 100176 (CN); LIU, He, Beijing 100176 (CN); LI, Xiaohui, Beijing 100176 (CN)
(74) Representative: Cohausz & Florack
(86) International application number: PCT/CN2024/119001
(87) International publication number: WO 2025/077528

(57) **Abstract**

The present disclosure provides a position calibration apparatus and semiconductor process equipment. The position calibration apparatus includes a first light curtain assembly disposed within the process chamber of the semiconductor process equipment. The first light curtain assembly includes a first light curtain emitting end, a first light curtain receiving end, a second light curtain emitting end, and a second light curtain receiving end located on a first plane. The first light curtain emitting end is configured to emit a first calibration light to a workpiece within the process chamber, and the first light curtain receiving end is configured to receive the first calibration light and obtain a first projection of the workpiece on the first light curtain receiving end. The second light curtain emitting end is configured to emit a second calibration light to the workpiece, and the second light curtain receiving end is configured to receive the second calibration light and obtain a second projection of the workpiece on the second light curtain receiving end. An angle between a projection of the first calibration light and a projection of the second calibration light on the first plane is greater than 0°. A controller is configured to determine the position information of the workpiece based on the first projection and the second projection.

## Description

### TECHNICAL FIELD

The present disclosure generally relates to the field of semiconductor manufacturing technology and, more particularly, to a position calibration apparatus and semiconductor process equipment.

### BACKGROUND

When semiconductor process equipment performs etching or deposition processes, wafer needs to be placed on a carrier apparatus within a vacuum process chamber. Furthermore, to improve the processing quality of semiconductor process equipment, whether the wafer is accurately placed in the designated position on the carrier apparatus needs to be determined before the process. After the process, the wafer also needs to be transferred to a designated position for the next process. This needs higher transfer accuracy and position calibration accuracy of the wafer.

### SUMMARY

The present disclosure aims to solve at least one of the technical problems in existing technology, and provides a position calibration apparatus and semiconductor process equipment.

To achieve the objectives of the present disclosure, a position calibration apparatus, applied to semiconductor process equipment is provided, including: a first light curtain assembly disposed within a process chamber of the semiconductor process equipment;
The first light curtain assembly includes a first light curtain emitting end, a first light curtain receiving end, a second light curtain emitting end, and a second light curtain receiving end located on a first plane;
The first light curtain emitting end is configured to emit a first calibration light onto a workpiece within the process chamber, and the first light curtain receiving end is configured to receive the first calibration light and obtain a first projection of the workpiece on the first light curtain receiving end;
The second light curtain emitting end is configured to emit a second calibration light onto the workpiece, and the second light curtain receiving end is configured to receive the second calibration light and obtain a second projection of the workpiece on the second light curtain receiving end; an angle between the a projection of the first calibration light and a projection of the second calibration light on the first plane is greater than 0°;

A controller is configured to determine position information of the workpiece based on the first projection and the second projection.

The process of determining the workpiece's position information based on the first projection and the second projection includes:
Determining the measured position of the workpiece on a first coordinate axis in a calibration coordinate system based on the first projection;
Determining the measured position of the workpiece on a second coordinate axis in the calibration coordinate system based on the second projection;
Determining the workpiece's position information based on the measured positions on the first coordinate axis and second coordinate axis in the calibration coordinate system.

The position calibration apparatus further includes a second light curtain assembly, which includes a third light curtain emitting end, a third light curtain receiving end, a fourth light curtain emitting end, and a fourth light curtain receiving end located on a second plane, the second plane being located above the first plane.

The third light curtain emitting end emits a third calibration light towards the robot arm extending into the process chamber, and the third light curtain receiving end receives the third calibration light and obtains a third projection of the robot arm on the third light curtain receiving end.

The fourth light curtain emitting end emits a fourth calibration light towards the robot arm, and the fourth light curtain receiving end receives the fourth calibration light and obtains a fourth projection of the robot arm on the fourth light curtain receiving end. An angle between a projection of the third calibration light and a projection of the fourth calibration light on the second plane is greater than 0°.

The controller is further configured to determine the position information of the robot arm based on the third projection and the fourth projection.

The position information of the robot arm includes horizontal offset and levelness of the robot arm.

Determining the position information of the robot arm based on the third projection and the fourth projection includes:
Determining the horizontal offset of the robot arm based on the third projection;
Determining the levelness of the robot arm based on the fourth projection.

Determining the horizontal offset of the robot arm based on the third projection includes:
Determining the measured position of a first designated point of the robot arm based on the third projection;
Determining the horizontal offset of the robot arm based on the measured position of the first designated point and the standard position corresponding to the first designated point.

Determining the levelness of the robot arm based on the fourth projection includes:
Determining the measured positions of a second and third designated point of the robot arm based on the fourth projection;
Determining the position information of the second designated point based on the measured position of the second designated point and the standard position corresponding to the second designated point; and determining the position information of the third designated point based on the third designated point and the standard position corresponding to the third designated point;
Determining the levelness of the robot arm based on the position information of the second designated point and the third designated point.

The second designated point includes a first endpoint of the lower surface of the robot arm, and the third designated point includes a second endpoint of the lower surface of the robot arm; or, the second designated point includes a second endpoint of the lower surface of the robot arm, and the third designated point includes a first endpoint of the lower surface of the robot arm.

An angle between the projection of the first calibration light and the projection of the extension/retraction direction of the robot arm onto the first plane is 30°-60°;
An angle between the projection of the second calibration light and the projection of the extension/retraction direction of the robot arm onto the first plane is 120°-150°;
An angle between the projection of the third calibration light and the projection of the extension/retraction direction of the robot arm onto the second plane is 30°-60°;
An angle between the projection of the fourth calibration light and the projection of the extension/retraction direction of the robot arm onto the second plane is 120°-150°.

The process chamber further includes a transfer port through which the robot arm enters and exits the process chamber.

The position calibration apparatus further includes a robot arm detection component for detecting the extension and retraction of the robot arm.

The robot arm detection component includes a first sensor and a second sensor, which are disposed inside the transfer port and opposite to each other, and are located on the second plane.

The first sensor includes a pressure sensor or a distance sensor; and the second sensor includes a pressure sensor or a distance sensor.

The controller is further configured to:
Acquire a first measured value from a first sensor and a first measured value from a second sensor during the extension of the robot arm into the process chamber;
Determine the extension/retraction amount of the robot arm based on the first measured value from the first sensor, the first measured value from the second sensor, and the horizontal offset of the robot arm;
Acquire a second measured value from the first sensor and a first rotation amount of the robot arm during the rotation of the robot arm toward the first sensor;
Determine an adjustment amount of the robot arm in a first direction based on the first rotation amount of the robot arm and the second measured value from the first sensor;
Acquire a second measured value from the second sensor and a second rotation amount of the robot arm during the rotation of the robot arm toward the second sensor;
Determine an adjustment amount of the robot arm in a second direction based on the second rotation amount of the robot arm and the second measured value from the second sensor.

An illumination height of the first calibration light and an illumination height of the second calibration light are greater than or equal to 3 mm;
The illumination height of the third calibration light and the fourth calibration light are greater than or equal to 8 mm.

The controller is further configured to:
When the ejector pins are in the raised state, determine whether the height difference between different ejector pins is within a preset height threshold range based on the first projection and the second projection; the ejector pins are used to lift and place the workpiece on the carrying surface of the carrier apparatus carrying the workpiece;
If the height difference between the ejector pins is within the height threshold range, and the height of the workpiece is consistent with the height of the ejector pins, determine that the workpiece is normal;
If the height difference between the ejector pins is within the height threshold range, and the height of the workpiece is inconsistent with the height of the ejector pins, determine that the workpiece has shifted;
If the height difference between the ejector pins is not within the height threshold range, determine that the workpiece has stuck.

To achieve the purpose of the present disclosure, semiconductor process equipment is also provided, including a position calibration apparatus, which includes the position calibration apparatus provided in the embodiments of the present disclosure.

The present disclosure has the following beneficial effects: The position calibration apparatus provided in the present disclosure includes a first light curtain assembly in a process chamber. The first light curtain assembly includes a first light curtain emitting end, a first light curtain receiving end, a second light curtain emitting end, and a second light curtain receiving end located on a first plane. The first light curtain emitting end is configured to emit a first calibration light to the workpiece in the process chamber, and the first light curtain receiving end is configured to receive the first calibration light and obtain a first projection of the workpiece at the first light curtain receiving end. The second light curtain emitting end is configured to emit a second calibration light to the workpiece, and the second light curtain receiving end is configured to receive the second calibration light and obtain a second projection of the workpiece at the second light curtain receiving end. The angle between the first calibration light and the second calibration light on the first plane is greater than 0°. The controller is configured to determine the position information of the workpiece based on the first projection and the second projection. Since the angle between the first calibration light and the second calibration light on the first plane is greater than 0°, the first projection and the second projection are obtained through the first light curtain receiving end and the second light curtain receiving end, respectively. The controller can determine the position information of the workpiece based on the first projection and the second projection, determine a state of the workpiece based on the position information of the workpiece, and take corresponding measures based on the state. For example, before the process is implemented, whether the workpiece has shifted during the descent can be determined; after implementation, whether the workpiece is within the focusing ring can be determined. If the workpiece deviates or shifts relative to the focusing ring, the robot arm can correct the workpiece during pick-up; as another example, the workpiece can be slid into the focusing ring by adjusting the height of the ejector pins. The controller can also determine whether the workpiece has stuck during the pins lifting process using the first projection and second projection. If workpiece has stuck, residual charge on the electrostatic chuck can be removed, thus systematically solving the problems of workpiece sticking and displacement.

### BRIEF DESCRIPTION OF THE DRAWINGS

FIG. 1 is a top view of a position calibration apparatus applied to semiconductor process equipment provided in the embodiments of the present disclosure;
FIG. 2 is a perspective view of the position calibration apparatus applied to semiconductor process equipment provided in the embodiments of the present disclosure;
FIG. 3 is a schematic structural diagram of semiconductor process equipment provided in the embodiments of the present disclosure;
FIG. 4 is a schematic diagram of a workpiece on a first plane in the embodiments of the present disclosure;
FIG. 5 is a flowchart of a position calibration method provided in the embodiments of the present disclosure;
FIG. 6 schematically shows a projection of a first light curtain assembly in the embodiments of the present disclosure;
FIG. 7 schematically shows calibrating the workpiece position using a standard coordinate system in the embodiments of the present disclosure;
FIG. 8 schematically shows calibrating the horizontal offset of a robot arm in the embodiments of the present disclosure;
FIG. 9 schematically shows calibrating the levelness of a robot arm in the embodiments of the present disclosure;
FIG. 10 schematically shows a projection of a second light curtain assembly in the embodiments of the present disclosure;
FIG. 11 schematically shows workpiece shifting in the embodiments of the present disclosure;
FIG. 12 schematically shows workpiece sticking in the embodiments of the present disclosure.

### DETAILED DESCRIPTION OF THE EMBODIMENTS

To enable those skilled in the art to better understand the technical solutions of the present disclosure, the position calibration apparatus, position calibration method, and semiconductor process equipment using the position calibration apparatus provided in the present disclosure will be described in detail below with reference to the accompanying drawings.

To facilitate the description of the position calibration apparatus provided in the embodiments of the present disclosure, a practical application scenario is used as an example, that is, applying the position calibration apparatus to semiconductor process equipment is used as an example. It should be noted that although the present disclosure uses applying the position calibration apparatus to semiconductor process equipment as an example, the present disclosure does not imply a limitation on the application scenario of the position calibration apparatus provided in the embodiments of the present disclosure. The position calibration apparatus provided in the embodiments of the present disclosure can also be applied to other semiconductor processing equipment.

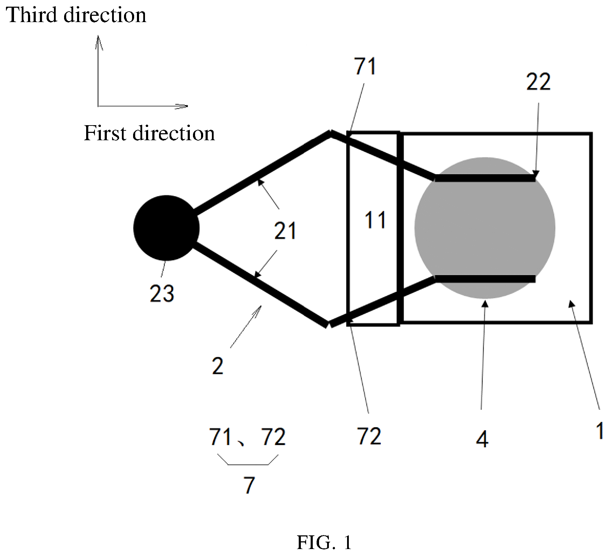

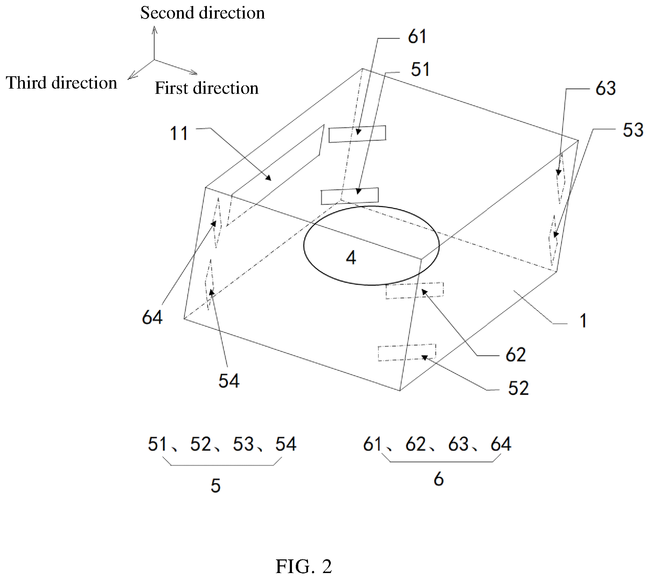

FIG. 1 is a top view of the position calibration apparatus applied to semiconductor process equipment provided in the embodiments of the present disclosure. This semiconductor process equipment may be, for example, deposition equipment, etching equipment, thermal processing equipment, cooling equipment, resist stripping equipment, or cleaning equipment. FIG. 2 is a perspective view of the position calibration apparatus applied to semiconductor process equipment provided in the embodiments of the present disclosure. As shown in FIGs. 1 and 2, the semiconductor process equipment includes a process chamber 1 and a robot arm 2 for transferring workpiece, such as a wafer. The process chamber 1 is used for processing the workpiece, and the robot arm 2 is used for transferring the workpiece, such as transferring the workpiece from outside the process chamber 1 to inside the process chamber 1, or transferring the workpiece from inside the process chamber 1 to outside the process chamber 1.

The robot arm 2 includes arms 21 and fingers 22. The finger 22 is located at the end of the arm 21 and is used to grasp workpiece. One end of the arm 21 is connected to a drive component 23. Under the drive of the drive component 23, the arm 21 can translate along a first direction, translate along a second direction (perpendicular to the plane of the paper), and rotate about a rotation axis parallel to the first direction. The first direction is perpendicular to the second direction. The other end of the arm 21 (i.e., the aforementioned end) is connected to the finger 22. The finger 22 moves with the arm 21 along the first direction, moves along the second direction, and rotates about a rotation axis parallel to the first direction.

In some embodiments, a transfer port 11 is provided on the wall of the process chamber 1. When the valve of the transfer port 11 is open, the robot arm 2 can extend into the process chamber 1 through the transfer port 11 to place or remove workpiece from the process chamber 1.

A carrier apparatus 4 is also provided inside the process chamber 1 for supporting the workpiece. The carrier apparatus 4 includes, but is not limited to, an electrostatic chuck, a vacuum adsorption chuck, and a mechanical chuck. In some embodiments, the carrier apparatus 4 is located at the bottom of the process chamber 1, and the upper surface of the carrier apparatus 4 serves as the support surface for supporting the workpiece. The transfer port 11 is located at the side wall of the process chamber 1, with the first direction perpendicular to the side wall where the transfer port 11 of the process chamber 1 is located. The robot arm 2 extends into the process chamber 1 from the transfer port 11, that is, the robot arm 2 extends into the process chamber 1 along the first direction and is located above the carrier apparatus 4. The aforementioned rotation axis of the robot arm 2 is parallel to the first direction and perpendicular to the side wall of the process chamber 1. The robot arm 2 can also move along a second direction, causing the workpiece to move away from or closer to the carrier apparatus 4.

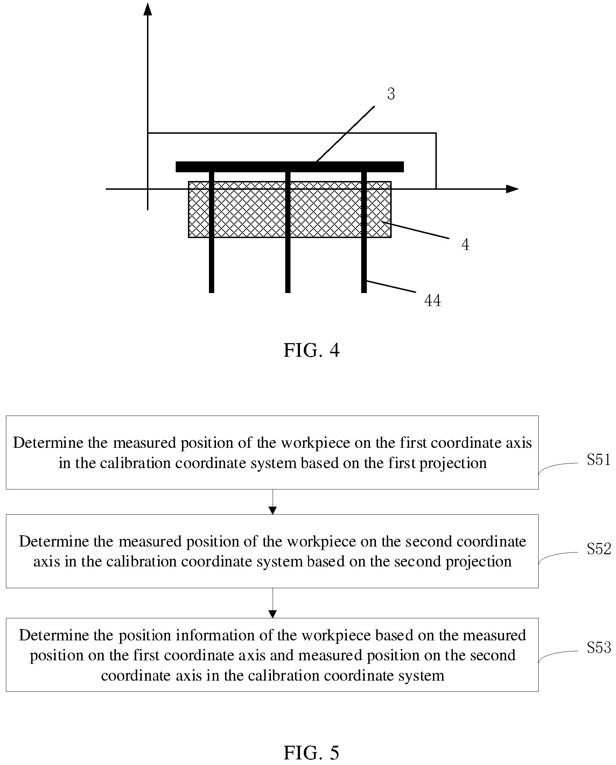

As shown in FIGs. 1, 2, and 4, a first plane in the embodiments of the present disclosure is a plane where the upper surface (i.e., the support surface) of the carrier apparatus 4 is located when processing the workpiece 3. A second plane refers to a plane parallel to the aforementioned first plane located at a certain distance directly above the carrier apparatus 4. The extension and retraction of the robot arm 2 can be measured by an extension/retraction amount R, and the rotation can be measured by a rotation amount δ. The height of the robot arm 2 within the process chamber 1 can be obtained by a reference value (height value, referred to as the BTO value). The present disclosure does not limit the BTO value; for example, the BTO value can be 3 mm. When the workpiece 3 carried by the robot arm 2 is positioned above a standard position directly facing the first plane, i.e., after the center of the workpiece 3 is aligned with the center of the carrying surface, multiple ejector pins 44 is raised to support the workpiece 3 (as shown in FIG. 4), so that the workpiece 3 is separated from the robot arm 2. The robot arm 2 withdraws from the process chamber 1, and the multiple ejector pins 44 descend to place the workpiece 3 on the carrying surface of the carrier apparatus 4. Similarly, after the process is completed, the multiple ejector pins 44 lift the workpiece 3 from the carrying surface of the carrier apparatus 4, the robot arm extends into the process chamber 1 to support the workpiece, the multiple ejector pins 44 descend, and the robot arm 2 withdraws from the process chamber 1 to remove the workpiece 3.

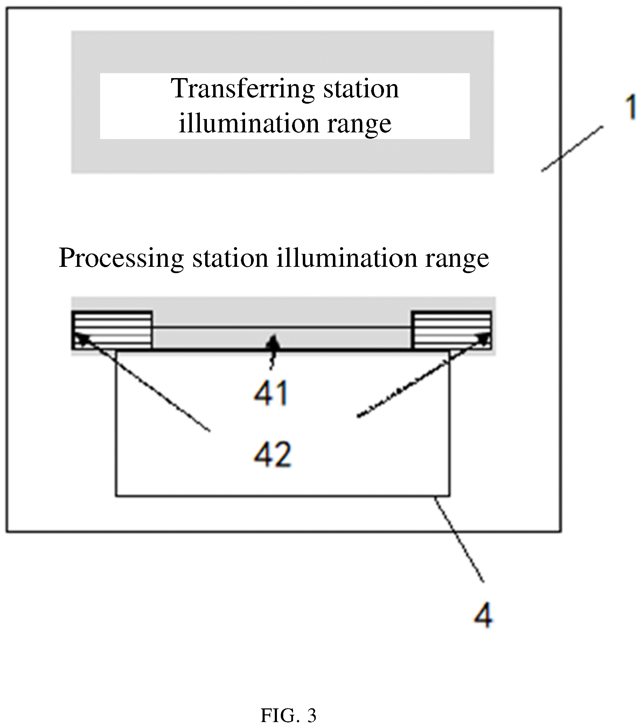

FIG. 3 a schematic structural diagram of semiconductor process equipment provided in the embodiments of the present disclosure, and FIG. 4 is a partial schematic structural diagram of the semiconductor process equipment provided in the embodiments of the present disclosure. As shown in FIG. 3 and FIG. 4, the carrier apparatus 4 includes an electrostatic chuck 41 and a focusing ring 42. The focusing ring 42 is annular and is disposed around the periphery of the carrying surface of the electrostatic chuck 41. During use, the workpiece 3 is placed on the carrying surface of the electrostatic chuck 41 and located inside the focusing ring 42. When a voltage is applied to the electrostatic chuck 41, an adsorption force is generated to attract the workpiece 3.

The ejector pins 44 can move upwards and extend beyond the carrying surface of the electrostatic chuck 41, meaning the top ends of the ejector pins 44 are above the carrying surface of the electrostatic chuck 41. The ejector pins 44 can also move downwards and be below the carrying surface of the electrostatic chuck 41, meaning the top ends of the ejector pins 44 are below the carrying surface of the electrostatic chuck 41.

As shown in FIGs. 1-4, the position calibration apparatus provided in the present disclosure includes a first light curtain assembly 5 disposed within the process chamber 1, which is configured to calibrate a position of the workpiece 3 on a first plane.

The first light curtain assembly 5 includes a first light curtain emitting end 51, a first light curtain receiving end 52, a second light curtain emitting end 53, and a second light curtain receiving end 54. The first light curtain emitting end 51 emits a first calibration light towards the workpiece 3 within the process chamber 1. The first light curtain receiving end 52 receives the first calibration light and obtains a first projection of the workpiece 3 onto the first light curtain receiving end 52. Specifically, the first standard light blocked by the workpiece 3 cannot be received by the first light curtain receiving end 52, while the first standard light not blocked by the workpiece 3 can be received by the first light curtain receiving end 52. The first light curtain receiving end 52 obtains the first projection of the workpiece 3 onto the first light curtain receiving end 52 based on the received first standard light.

The second light curtain emitting end 53 emits a second calibration light towards the workpiece 3. The second light curtain receiving end 54 receives the second calibration light and obtains a second projection of the workpiece 3 onto the second light curtain receiving end 54. Specifically, the second standard light blocked by workpiece 3 cannot be received by the second light curtain receiving end 54, while the second standard light not blocked by workpiece 3 can be received by the second light curtain receiving end 54. The second light curtain receiving end 54 can obtain the second projection of workpiece 3 onto the second light curtain receiving end 54 based on the received second standard light.

In the present disclosure, an angle between a projection of the first calibration light and a projection of the second calibration light onto the first plane is greater than 0°, meaning the first calibration light and the second calibration light are not parallel. For example, the angle between the projection of the first calibration light and the projection of the second calibration light onto the first plane is 45°, 90°, or other angles. This means the first calibration light and the second calibration light project onto workpiece 3 from different angles, and the first projection and second projection obtained are projections of workpiece 3 from two different angles. Compared to determining the position of workpiece 3 based on a projection from a single angle, the present disclosure provides a more accurate method for determining the position information of workpiece 3 on the first plane based on the first projection and second projection.

By obtaining the first projection and second projection respectively through the first light curtain receiving end 52 and the second light curtain receiving end 54, a controller can determine the position information of workpiece 3 based on the first projection and second projection, determine a state of the workpiece 3 based on the position information of the workpiece 3, and take corresponding measures based on the state. For example, before the process is implemented, whether the workpiece 3 deviates during the descent can be determined; after the process is implemented, whether the workpiece 3 is within the focusing ring 42 can be determined. If workpiece 3 deviates or shifts relative to the focusing ring 42, the robot arm 2 can correct the deviation of workpiece 3 when picking up the piece; or, the height of the ejector pins 44 can be adjusted to make workpiece 3 slide into the focusing ring 42. The controller can also determine whether the workpiece has stuck during the lifting of the ejector pins through the first projection and second projection. If the workpiece has stuck, the residual charge on the electrostatic chuck 41 can be removed, thus systematically solving the problems of workpiece sticking and displacement. In addition, the state of the ejector pins 44 can also be determined based on the first projection and second projection, such as whether the top of the ejector pins 44 are flush.

As shown in FIG. 2, the first light curtain emitting end 51 is located on the side of the transfer port 11. The angle between the projection of the first calibration light emitted by the first light curtain emitting end 51 and the projection of the extension/retraction direction of the robot arm 2 onto the first plane is 30°-60°, for example, the angle is 30°, 40°, 45°, 50°, 55° or 60°.

The angle between the second calibration light emitted from the second light curtain emitting end 53 and the projection of the extension/retraction direction of the robot arm 2 onto the first plane is 120°-150°, for example, 120°, 130°, 140°, or 150°. When adjusting the angle between the projections of the first calibration light and the extension/retraction direction of the robot arm 2 onto the first plane, and the angle between the a projection of the first calibration light and a projection of the second calibration light onto the first plane, the angle can be 90° to more accurately determine the position of the workpiece 3 on the first plane, thus facilitating the calibration of the workpiece 3's position.

In some embodiments, illumination heights of the first calibration light and the second calibration light are greater than or equal to 3mm, that is, the illumination height generated by the first calibration light on the first light curtain receiving end 52 is greater than or equal to 3mm, for example, 3mm or 5mm. The illumination height generated by the second calibration light on the second light curtain receiving end 54 is greater than or equal to 3mm, for example, 3mm or 5mm. Illumination range of the first calibration light and the second calibration light is the "processing station illumination range" covering the electrostatic chuck 41 and the focusing ring 42 in FIG. 3.

The first calibration light and the second calibration light can be used to calibrate the position of workpiece 3. In practical applications, workpiece 3 may experience shifting or sticking. In such cases, the first calibration light and the second calibration light can be used to determine whether the workpiece 3 has shifted or stuck. If the position of workpiece 3 needs to be adjusted, for example, the verticality, horizontality, and height of workpiece 3 can be calibrated using the first calibration light and the second calibration light to ensure that the verticality, horizontality, and height of the workpiece are within a preset threshold range.

In some embodiments, the position of the first projection of workpiece 3 can be expressed in a first coordinate system, and the position of the second projection of workpiece 3 can be expressed in a second coordinate system. However, whether the position of workpiece 3 is in a preset position needs to be determined in a standard coordinate system within the first plane. Therefore, the position of workpiece 3 in the first coordinate system and second coordinate system need to be mapped to the standard coordinate system.

The position calibration apparatus further includes a controller (not shown in the figure), configured to determine the measured position of the workpiece 3 on a first coordinate axis in the calibration coordinate system based on a first projection, and to determine the measured position of the workpiece 3 on a second coordinate axis in the calibration coordinate system based on a second projection, and to determine the measured position of the workpiece 3 based on the measured position on the first coordinate axis and measured position on the second coordinate axis in the calibration coordinate system.

In some embodiments, the controller is configured to determine the measured position of the workpiece 3 in the first coordinate system based on the first projection, and to determine the measured position of the workpiece 3 in the second coordinate system based on the second projection, and to determine the measured position of the workpiece 3 in the calibration coordinate system based on the measured positions in the first coordinate system and second coordinate system. In some embodiments, the first coordinate system includes a first coordinate axis and a second coordinate axis, and the second coordinate system includes a first coordinate axis and a second coordinate axis, the first coordinate axis of the first coordinate system and the first coordinate axis of the second coordinate system respectively corresponding to a first coordinate axis and a second coordinate axis of the calibration coordinate system; the measured position in the first coordinate system includes the measured position on the first coordinate axis in the first coordinate system, and the measured position in the second coordinate system includes the measured position on the first coordinate axis in the second coordinate system.

The present disclosure does not limit the position information of the workpiece. The position information of the workpiece can be either a relative position or an absolute position. When the workpiece's position information is a relative position, the position information of the workpiece includes position information between the workpiece and the carrier apparatus. When the workpiece's position information is an absolute position, the position information of the workpiece includes position information of workpiece within the process chamber.

In some embodiments, determining the workpiece's position information based on a first projection and a second projection includes: determining the workpiece's measured position in the calibration coordinate system based on the measured position on the first coordinate axis in the first coordinate system and the measured position on the first coordinate axis in the second coordinate system.

For example, FIG. 5 is a flowchart of a position calibration method provided in the embodiments of the present disclosure. As shown in FIG. 5, the process of determining the workpiece's position information based on the first projection and the second projection includes:
S51, determine the measured position of the workpiece on the first coordinate axis in the calibration coordinate system based on the first projection.

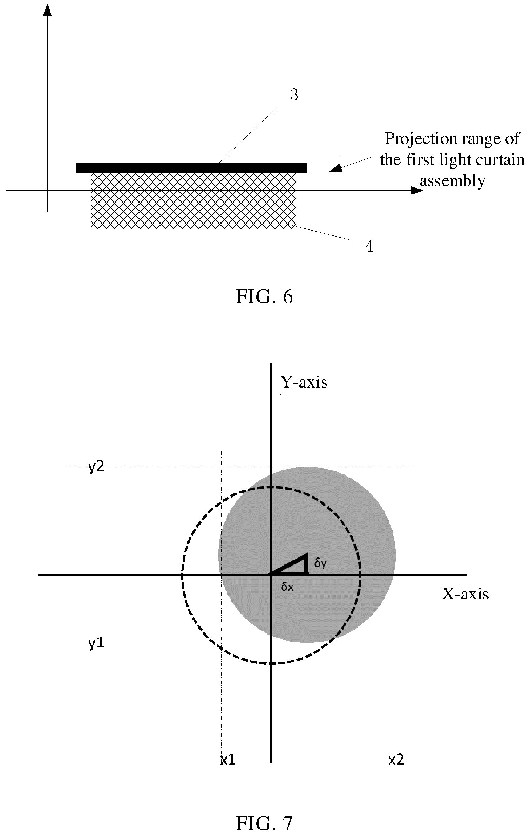

As shown in FIG. 6, a first projection of the workpiece 3 (viewed from the light source side of the first calibration light) is obtained. The measured position of the workpiece is represented in the first projection by the first coordinate system, where the first coordinate axis (horizontal axis) represents the position of the workpiece 3 in the first plane, and the second coordinate axis (vertical axis) represents the height of the workpiece 3. The measured position of the workpiece in the first coordinate system can be determined based on the horizontal coordinate in the first projection.

The measured position on the second coordinate axis is the height of the workpiece. Based on the workpiece height, whether the workpiece experiences shifting or sticking issues can be determined, and the height of the ejector pins can also be determined for ejector pins height calibration.

S52, determine the measured position of the workpiece on the second coordinate axis in the calibration coordinate system based on the second projection.

As shown in FIG. 6, obtain the second projection of workpiece 3 (viewed from the light source side of the second calibration light). The measured position of the workpiece is represented in the second projection by the second coordinate system. In the second coordinate system, the first coordinate axis (horizontal axis) represents the position of workpiece 3 perpendicular to the direction of the second calibration light, and the second coordinate axis (vertical axis) represents the workpiece height. It should be noted that the first projection and the second projection differ only in angle, and the first projection and the second projection both are projections onto the workpiece.

The measured position on the second coordinate axis is the height of the workpiece. Based on the workpiece height, whether the workpiece experiences shifting or sticking issues can be determined, and the height of the ejector pins can also be determined for ejector pins height calibration.

S53, determine the position information of the workpiece based on the measured position on the first coordinate axis and measured position on the second coordinate axis in the calibration coordinate system.

In the calibration coordinate system, the first coordinate axis and second coordinate axis are two mutually perpendicular coordinate axes in the standard coordinate system within the first plane, as shown in FIG. 7. The first coordinate axis is the X-axis, and the second coordinate axis is the Y-axis.

The measured position on the first coordinate axis (X-axis) in the calibration coordinate system can be determined based on the measured position on the first coordinate axis in the first coordinate system, and the measured position on the second coordinate axis (Y-axis) can be determined based on the measured position on the first coordinate axis in the second coordinate system.

Specifically, the measured position on the first coordinate axis in the first coordinate system is used as the measured position on the first coordinate axis in the calibration coordinate system, and the measured position on the first coordinate axis in the second coordinate system is used as the measured position on the second coordinate axis in the calibration coordinate system. Then, the workpiece's position information (measured position) in the standard coordinate system is determined. Based on the workpiece's position information and a preset standard position, such as determining whether the workpiece's measured position coincides with the preset standard position, the workpiece's position is calibrated.

The measured position on the first coordinate axis in the first coordinate system serves as the measured position of the workpiece on the first coordinate axis in the calibration coordinate system. Specifically, the measured position on the first coordinate axis (horizontal axis) in the first coordinate system corresponds to the measured positions (x1 and x2) on the first coordinate axis in FIG. 7.

The measured position on the first coordinate axis in the second coordinate system serves as the measured position of the workpiece on the second coordinate axis in the calibration coordinate system. Specifically, the measured position on the first coordinate axis (horizontal axis) in the second coordinate system corresponds to the measured positions (y1 and y2) of the second coordinate axis in FIG. 7.

As shown in FIG. 7, the shaded area represents the measured position of the workpiece on the first plane, and the thick dashed line represents a first standard position. When the overlap between the measured position of the workpiece and the first standard position reaches a preset overlap threshold, the position calibration of the workpiece is complete. For example, when the overlap reaches 99%, the position calibration of the workpiece is considered complete.

In some embodiments, as shown in FIG. 2, the position calibration apparatus further includes a second light curtain assembly 6 disposed within the process chamber for calibrating the positions of the robot arm and the workpiece on the second plane.

The second light curtain assembly 6 includes a third light curtain emitting end 61, a third light curtain receiving end 62, a fourth light curtain emitting end 63, and a fourth light curtain receiving end 64, all located on a second plane, and the second plane is positioned above the first plane.

The third light curtain emitting end 61 emits a third calibration light to a robot arm extending into the process chamber 1. The third light curtain receiving end 62 receives the third calibration light and obtains a third projection of the robot arm on the third light curtain receiving end. Specifically, the third standard light blocked by the robot arm cannot be received by the third light curtain receiving end 62, while the unblocked third standard light can be received by the third light curtain receiving end 62. The third light curtain receiving end 62 obtains the third projection of the robot arm based on the received third standard light.

The fourth light curtain emitting end 63 emits a fourth calibration light to the robot arm extending into the process chamber 1. The fourth light curtain receiving end 64 receives the fourth calibration light and obtains a fourth projection of the robot arm on the fourth light curtain receiving end. Specifically, the fourth standard light blocked by the robot arm cannot be received by the fourth light curtain receiving end 64, while the unblocked fourth standard light can be received by the fourth light curtain receiving end 64. The fourth light curtain receiving end 64 can obtain the fourth projection of the robot arm based on the received fourth standard light.

The third light curtain emitting end 61 and the third light curtain receiving end 62 are positioned on opposite sides of the second plane, and the robot arm extending into the process chamber 1 is located on the optical path of the third calibration light. When the robot arm 2 extends into the process chamber 1, the third calibration light can project onto the robot arm 2, and the third light curtain receiving end 62 receives the third calibration light and obtains the third projection of the robot arm 2.

The fourth light curtain emitting end 63 and the fourth light curtain receiving end 64 are positioned on opposite sides of the second plane, and the robot arm is located on the optical path of the fourth calibration light. When the robot arm 2 extends into the process chamber 1, the fourth calibration light can project onto the robot arm 2, and the fourth light curtain receiving end 64 receives the fourth calibration light and obtains the fourth projection of the robot arm.

An angle between a projection of the third calibration light and a projection of the fourth calibration light onto the second plane is greater than 0°, meaning the third calibration light and the fourth calibration light are not parallel. For example, the angle between the projection of the third calibration light and the projection of the fourth calibration light onto the second plane could be 45°, 90°, or other angles, indicating the third calibration light and the fourth calibration light project onto the robot arm from different angles, allowing for more accurate position calibration of the robot arm.

When the robot arm is not carrying a workpiece and extends into the process chamber, the third projection and the fourth projection can be used to calibrate the position of robot arm without opening the chamber or disrupting the vacuum levelness, reducing environmental pollution. For example, the robot arm's horizontal offset and levelness can be calibrated. The horizontal offset includes offset in a first direction (the robot arm's extension/retraction direction) and offset in a third direction. The levelness includes levelness in the first direction and levelness in the third direction. When the robot arm is carrying a workpiece, the third projection and the fourth projection can also be used to obtain the workpiece's position information, allowing for adjustments of the workpiece's position in the first direction and the second direction, thus achieving workpiece's position calibration.

As shown in FIG. 2, the third light curtain emitter 61 is positioned at the side of the transfer port 11, which is located on the second plane. The angle between the projection of the third calibration light emitted by the third light curtain emitter 61 and the projection of the extension/retraction direction (first direction) of the robot arm 2 onto the second plane is 30°-60°, for example, 30°, 40°, 45°, 50°, 55°, or 60°.

The angle between the projection of the fourth calibration light emitted by the fourth light curtain emitter 63 and the projection of the extension/retraction direction (first direction) of the robot arm 2 onto the second plane is 120°-150°, for example, 120°, 130°, 140°, or 150°. When the angle between the projection of the third calibration light and the extension/retraction direction of the robot arm onto the second plane is adjusted, the angle between the projection of the third calibration light and the projection of the fourth calibration light on the second plane can be 90°, thus the position of the robot arm on the second plane can be more accurately determined, facilitating robot arm position calibration.

In some embodiments, an illumination height of the third calibration light is greater than 8mm, meaning the illumination height generated by the third calibration light on the third light curtain receiving end 62 is greater than 8mm, for example, 8mm or 10mm. The illumination height of the fourth calibration light is greater than 8mm, meaning the illumination height generated by the fourth calibration light on the fourth light curtain receiving end 64 is greater than 8mm, for example, 8mm or 10mm. The illumination height of the third calibration light is the area that starts from the surface of the carrier apparatus, i.e., the area above the surface of the carrier apparatus. The illumination range of the third calibration light and the fourth calibration light is the "transferring station illumination range" in FIG. 3.

In some embodiments, the controller is also used to determine the position information of the robot arm based on the third projection and the fourth projection. The position information of the robot arm includes horizontal offset and levelness of the robot arm.

In some embodiments, determining the position information of the robot arm based on the third projection and the fourth projection includes: determining the horizontal offset of the robot arm based on the third projection; and determining the levelness of the robot arm based on the fourth projection.

In some embodiments, determining the horizontal offset of the robot arm based on the third projection includes: determining the measured position of a first designated point of the robot arm based on the third projection; and determining the horizontal offset of the robot arm based on the measured position of the first designated point and the standard position corresponding to the first designated point. The first designated position can be an endpoint of the robot arm, such as the left front endpoint or right front endpoint; any position that allows for horizontal offset calibration can be used as the first designated position. It should be noted that in the present disclosure, the robot arm includes a left finger and a right finger. The left front endpoint refers to the tip of the left finger, and the right front endpoint refers to the tip of the right finger.

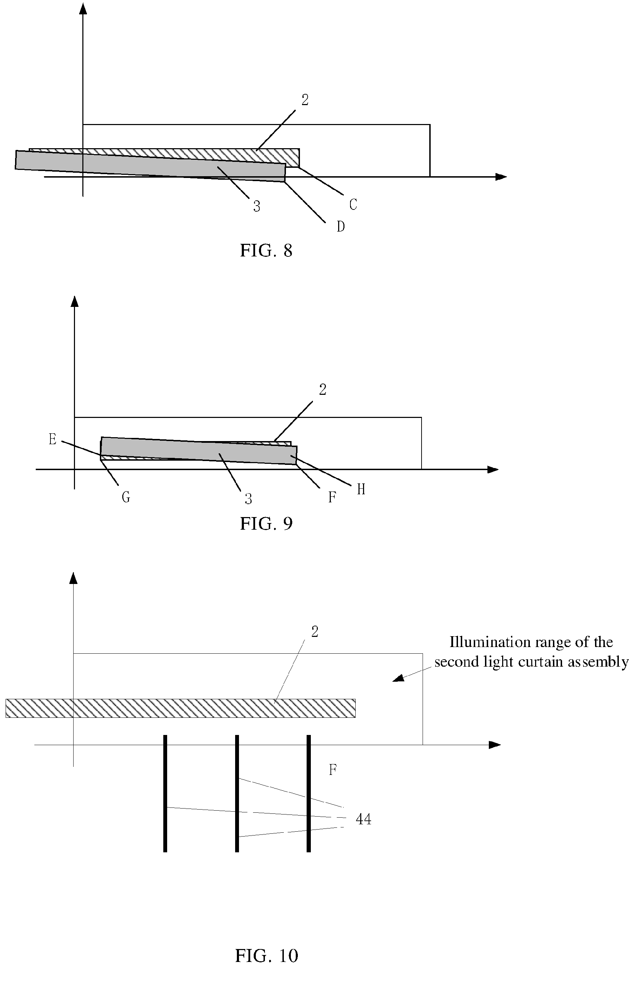

As shown in FIG. 8, the first designated point of the robot arm 3 can be the left front endpoint of the robot arm. A measured position D of the first designated point can be obtained from the third projection. When the difference between the measured position D of the first designated point and a standard position C corresponding to the first designated point is large, indicating that the horizontal offset of the robot arm 3 is large, and vice versa. When the horizontal offset is less than a preset first threshold, the horizontal offset of the robot arm 3 is determined to meet the calibration requirement.

Specifically, the measured position of the first designated point of the robot arm is determined based on the third projection; a first position difference is determined based on the measured position of the first designated point and the corresponding standard position; if the first position difference is equal to or less than a preset first threshold, the horizontal offset of the robot arm is calibrated; if the first position difference is greater than the preset first threshold, the horizontal offset of the robot arm is further calibrated.

For example, as shown in FIG. 8, the gray area is the actual projection of robot arm3, and the shaded area 2 is the standard position of the robot arm. Determining the horizontal offset of the robot arm based on the third projection includes:
S71, obtaining the measured position of the first designated point of the robot arm in the third projection.

Assuming the first designated point is the left front endpoint of the robot arm, the measured position D of the first designated point is obtained from the first projection.

S72, obtaining the first position difference between the measured position of the first designated point and the standard position of the first designated point.

The standard position of the first designated point refers to the standard position of the left front endpoint of the robot arm, as shown by the standard position of the first designated point C in FIG. 8. Calculating the measured position of the first designated point and the standard position of the first designated point allows us to determine the distance difference between the measured position of the first designated point and the standard position of the first designated point, thus obtaining the first position difference, such as the distance between points C and D.

S73: if the first position difference is equal to or less than a preset first threshold, the horizontal offset of the robot arm is calibrated. If the first position difference is greater than the preset first threshold, the horizontal offset of the robot arm is further calibrated using the first projection.

The first threshold is a preset threshold that can be set according to the workpiece's machining accuracy, the present disclosure does not limit on this. When the first position difference is equal to or less than the first threshold, the horizontal offset of the robot arm meets the preset requirements. When the first position difference is greater than the first threshold, the horizontal offset of the robot arm does not meet the preset requirements, and the robot arm's horizontal offset needs to be further calibrated, such as extension/retraction movement, rotation in a first direction, or rotation in a second direction.

In some embodiments, determining the levelness of the robot arm based on the fourth projection includes: determining the a measured position of a second designated point and a measured position of a third designated point of the robot arm based on the fourth projection; determining the position information of the second designated point based on the measured position of the second designated point and the standard position corresponding to the second designated point; and determining the position information of the third designated point based on the measured position of the third designated point and the standard position corresponding to the third designated point; and determining the levelness of the robot arm based on the position information of the second designated point and the third designated point.

For example, as shown in FIG. 9, the gray area represents the actual projection of the robot arm 3, and the shaded area 2 represents the standard position of the robot arm. Determining the levelness of the robot arm based on the fourth projection includes:
S81, obtaining the measured positions of the second designated point and the third designated point of the robot arm in the fourth projection.

The second designated point and the third designated point can be any two points capable of calibrating the levelness of the robot arm. For example, the second designated point includes the left endpoint of the lower surface of the robot arm, and the third designated point includes the right endpoint of the lower surface of the robot arm; that is, the second designated point is the lower left endpoint E of the robot arm, and the third designated point is the lower right endpoint F of the robot arm.

S82, obtaining a second position difference between the measured position of the second designated point and the standard position of the second designated point, and obtaining a third position difference between the measured position of the third designated point and the standard position of the third designated point.

The standard position of the second designated point is G, and the standard position of the third designated point is H (obscured by the gray area). Calculate the second position difference between the measured position E of the second designated point and the standard position G of the second designated point, and calculate the third position difference between the measured position F of the third designated point and the standard position H of the third designated point.

S83, if both the second position difference and the third position difference are equal to or less than a preset second threshold, the calibration of the robot arm's levelness is completed; if at least one of the second position difference or the third position difference is greater than the second threshold, the robot arm's levelness is further calibrated using the second projection.

It should be noted that in the present disclosure, the second designated point includes the first endpoint (e.g., the left endpoint) of the lower surface of the robot arm, the third designated point includes the second endpoint (e.g., the right endpoint) of the lower surface of the robot arm, and the second designated point can also include the second endpoint of the lower surface of the robot arm, and the third designated point can also include the first endpoint of the lower surface of the robot arm. However, the present disclosure is not limited to this; the second designated point and the third designated point can also be other suitable position points.

In some embodiments, as shown in FIG1, the position calibration apparatus further includes a robot arm detection component 7 for detecting extension and retraction amount of the robot arm 2.

The robot arm detection component 7 includes a first sensor 71 and a second sensor 72. The first sensor 71 and the second sensor 72 are disposed inside the transfer port 11 and are arranged opposite to each other, and the first sensor 71 and the second sensor 72 are disposed on the second plane.

In some embodiments, the first sensor 71 includes a pressure sensor or a distance sensor; and the second sensor 72 includes a pressure sensor or a distance sensor.

The controller in the present disclosure is further configured to: acquire a first measured value from the first sensor 71 and a first measured value from the second sensor 72 during the process of the robot arm extending into the process chamber 1; determine the extension/retraction amount of the robot arm 2 based on the first measured value from the first sensor 71, the first measured value from the second sensor 72, and the horizontal offset of the robot arm 2; acquire a second measured value from the first sensor 71 and a first rotation amount of the robot arm 2 during the rotation of the robot arm 2 toward the first sensor 71; determine an adjustment amount of the robot arm 2 in a first direction based on the first rotation amount of the robot arm 2 and the second measured value from the first sensor 71; acquire a second measured value from the second sensor 72 and a second rotation amount of the robot arm 2 during the rotation of the robot arm 2 toward the second sensor 72; and determine an adjustment amount of the robot arm 2 in a second direction based on the second rotation amount of the robot arm 2 and the second measured value from the second sensor 72.

The following uses a pressure sensor as an example to illustrate the robot arm's extension/retraction amount detected by the robot arm detection component.

As shown in FIG. 1, when the robot arm 2 moves into the process chamber 1, the robot arm 2 squeezes the first sensor 71 and the second sensor 72. The first sensor 71 and the second sensor 72 obtain measured values (pressure values), i.e., the first measured values from the first sensor 71 and the second sensor 72 respectively. When the first measured values of the first sensor 71 and the second sensor 72 respectively reach a preset measured threshold, the extension/retraction amount of the robot arm 2 into the process chamber 1 is the maximum extension/retraction amount R.

When the robot arm 2 rotates towards the first sensor 71 (rotates to the left), the robot arm 2 squeezes the first sensor 71, and the first sensor 71 obtains a second measured value. When the second measured value obtained by the first sensor 71 reaches a preset measured threshold, the maximum rotation amount δleft of the robot arm 2 towards the first sensor 71 can be determined. Similarly, when the robot arm 2 rotates towards the second sensor 72 (rotates to the right), the robot arm 2 squeezes the second sensor 72, and the second sensor 72 obtains a second measured value. When the second measured value obtained by the second sensor 72 reaches a preset measured threshold, the maximum rotation amount δright of the robot arm 2 towards the second sensor 72 can be determined. The rotation direction towards the first sensor 71 is opposite to the rotation direction towards the second sensor 72; for example, the rotation direction towards the first sensor 71 is clockwise, and the rotation direction towards the second sensor 72 is counterclockwise.

In the present disclosure, after the first sensor 71 and the second sensor 72 obtain measured values, the controller calibrates the position of the robot arm on the second plane based on these measured values.

In some embodiments, before the position of the workpiece on the first plane is calibrated, the controller is further configured to:
S91, during the process of the robot arm extending into the process chamber, acquire the first measured value from the first sensor and the first measured value from the second sensor.

The first sensor and the second sensor can be pressure sensors or distance sensors. The following explanation uses a pressure sensor as an example. The first measured value from the first sensor and the first measured value from the second sensor are pressure values. The rotation direction towards the first sensor 71 is the first direction, and the rotation direction towards the second sensor 72 is the second direction, and the first direction and the second direction are opposite.

S92, based on the first measured value from the first sensor, the first measured value from the second sensor, and the horizontal offset of the robot arm, determine the extension/retraction amount of the robot arm.

When the first measured value from the first sensor and the first measured value from the second sensor reach a preset pressure threshold, the horizontal offset of the robot arm is recorded. This horizontal offset is the maximum extension/retraction amount R of the robot arm.

S93, during the rotation of the robot arm towards the first sensor, the second measured value from the first sensor and the first rotation amount of the robot arm are acquired.

S94, based on the first rotation amount of the robot arm and the second measured value from the first sensor, the adjustment amount of the robot arm in the first direction is determined.

When the second measured value from the first sensor reaches the preset pressure threshold, the first rotation amount of the robot arm is recorded, and this first rotation amount is determined as the maximum adjustment amount δleft of the robot arm in the first direction.

S95, during the rotation of the robot arm towards the second sensor, the second measured value from the second sensor and the second rotation amount of the robot arm are acquired.

S96, based on the second rotation amount of the robot arm and the second measured value from the second sensor, the adjustment amount of the robot arm in the second direction is determined.

When the second measured value from the second sensor reaches the preset pressure threshold, the second rotation amount of the robot arm is recorded, and this second rotation amount is determined as the maximum adjustment amount δright of the robot arm in the second direction.

In some embodiments, the reference value is determined by using a second light curtain assembly to determine the BTO value.

Specifically, as shown in FIG. 10, the robot arm is adjusted along the second direction based on the projections of the third projection and the fourth projection generated by the second light curtain assembly, so that the BTO value of the robot arm reaches a preset reference value, for example, 3mm, meaning the height difference between the upper surface of the robot arm and the top end of the ejector pins are 3mm.

After the maximum rotation amount δleft of the robot arm in the first direction, the maximum rotation amount δright in the second direction, and the extension/retraction amount R are determined, the position information of the robot arm is recorded, such as extension/retraction amount R ∈ (0, R + Rmax), rotation amount δ ∈ (δ - δleft, δ + δright), and BTO. In some embodiments, the descent amount of the robot arm can also be determined, which is usually a fixed value, such as 6mm.

Before the process is implemented, the robot arm carries the workpiece and transfers the workpiece into the process chamber, using the recorded extension/retraction amount R, rotation amount δ, and BTO value as the initial position of the robot arm. The second light curtain assembly is activated, the measured position of the workpiece when the robot arm is carrying the workpiece is recorded and compared to the initial position, and the robot arm's R∈(0, R+Rmax) and δ∈(δ-δleft, δ+δright) are finely adjusted to ensure the workpiece reaches the second plane. The ejector pins are raised, the workpiece is placed on the ejector pins. The robot arm retracts from the process chamber, and then the pin is lowered, the workpiece is placed on the carrier apparatus. The first light curtain assembly is activated to detect whether the workpiece is on the first plane after the pin is lowered, as shown in FIG. 6. If the difference between the workpiece's position and the standard position exceeds a normal range, an ejector pins abnormality is identified. If the difference is within the normal range, the process can proceed.

In some embodiments, the first light curtain assembly can be used to calibrate the levelness, workpiece sticking, and workpiece shifting of the ejector pins.

In some embodiments, the first light curtain assembly is configured to adjust the ejector pin's levelness. Specifically, the controller is further configured to: when the ejector pins are in the raised state, determine whether the height difference between different ejector pins is within a preset height threshold range based on a first projection and a second projection; the ejector pins are configured to lift and place the workpiece on the carrying surface of the carrier apparatus that carries the workpiece; if the height difference between the ejector pins is within the height threshold range and the height of the workpiece is consistent with the height of the ejector pins, determine that the workpiece is normal; if the height difference between the ejector pins is within the height threshold range but the height of the workpiece is inconsistent with the height of the ejector pins, determine that the workpiece has shifted; if the height difference between the ejector pins is not within the height threshold range, determine that the workpiece has stuck.

In some embodiments, the process of adjusting the levelness of the ejector pins using the first light curtain assembly includes: when the ejector pins are in the raised state, determining whether the height difference between different ejector pins is within a preset height threshold range based on a first projection obtained by the first light curtain receiving end and a second projection obtained by the second light curtain receiving end; if yes, determining that the levelness of the ejector pins meets the preset requirements; if not, adjusting the height of the ejector pins individually using an electric drive device until the height difference between different ejector pins is within the preset height threshold range.

After the process is completed, the ejector pins are raised, and the first light curtain assembly is configured to detect whether the workpiece has stuck or shifted. As shown in FIG. 6, if the height difference between different ejector pins is within a preset height threshold range, and the height of the workpiece is consistent with the height of the ejector pins, then the workpiece is determined to be normal, and the robot arm enters the process chamber to retrieve the workpiece.

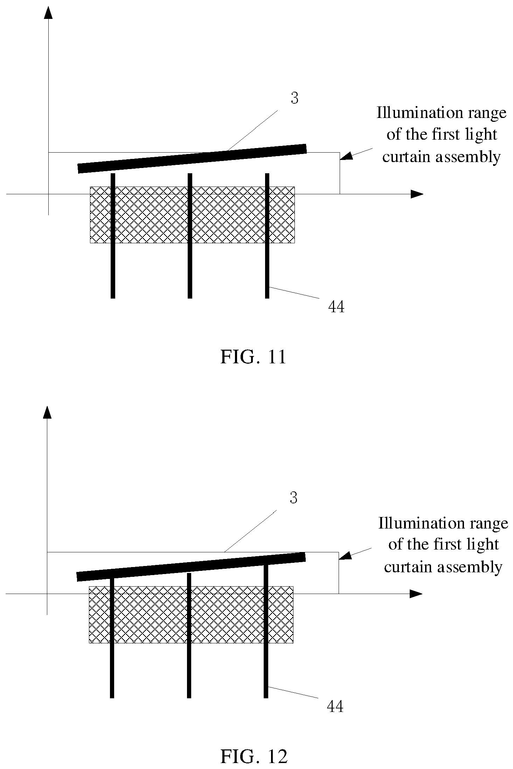

As shown in FIG. 11, when the height difference between different ejector pins 44 is within a preset height threshold range, but the height of workpiece 3 is inconsistent with the height of ejector pins 44, it is determined that workpiece 3 has shifted. The position of workpiece 3 relative to the focusing ring is observed through the first light curtain assembly. If the workpiece is within the focusing ring, the ejector pins are raised; the workpiece enters the light curtain detection range corresponding to the second plane, and the robot arm calibrates and retrieves the workpiece. If the workpiece slides out of the focusing ring, the ejector pins are controlled to raise the pins on the focusing ring side, allowing the workpiece to slide back into the focusing ring. If multiple attempts fail to slide the workpiece back into the focusing ring, the chamber is opened for workpiece retrieval.

As shown in FIG. 12, if height the ejector pins are abnormal, it is determined that workpiece 3 has stuck. The gas pressure in the process chamber to controlled by nitrogen gas, the pins 44 are raised, and the workpiece is desorbed again. Then the ejector pins are raised and the state of workpiece 3 is detected.

In some embodiments, as shown in FIG. 2, the first light curtain assembly also includes a protective screen (not shown). The surfaces of the first light curtain emitting end 51, the second light curtain emitting end 53, the first light curtain receiving end 52, and the second light curtain receiving end 54 are all equipped with protective screens.

The second light curtain assembly 6 also includes protective screens. Protective screens are provided on the surfaces of the third light curtain emitting end, fourth light curtain emitting end, third light curtain receiving end, and fourth light curtain receiving end.

The protective screens protect the first light curtain assembly 5 and the second light curtain assembly 6 during the process, preventing the surfaces of the first light curtain assembly 5 and the second light curtain assembly 6 from being etched by plasma. Simultaneously, the protective screens prevent contamination of the process chamber due to etching of the first light curtain assembly 5 and the second light curtain assembly 6. In other words, the protective screens protect both the first light curtain assembly 5 and the second light curtain assembly 6, and also prevent contamination of the process chamber 1.

In some embodiments, the protective screens are made of sapphire or mica sheets.

The position calibration apparatus provided in the present disclosure includes a first light curtain assembly installed in a process chamber. The first light curtain assembly includes a first light curtain emitting end, a first light curtain receiving end, a second light curtain emitting end, and a second light curtain receiving end located on a first plane. The first light curtain emitting end emits a first calibration light to the workpiece in the process chamber, and the first light curtain receiving end receives the first calibration light and obtains a first projection of the workpiece at the first light curtain receiving end. The second light curtain emitting end emits a second calibration light to the workpiece, and the second light curtain receiving end receives the second calibration light and obtains a second projection of the workpiece at the second light curtain receiving end. The angle between the first calibration light and the second calibration light on the first plane is greater than 0°. The controller determines the position information of the workpiece based on the first projection and the second projection. Since the angle between the first calibration light and the second calibration light on the first plane is greater than 0°, the first projection and the second projection are obtained through the first light curtain receiving end and the second light curtain receiving end, respectively. The controller can determine the position information of the workpiece based on the first projection and the second projection, determine the state of the workpiece based on the position information of the workpiece, and take corresponding measures based on the state. For example, before the process is implemented, whether the workpiece deviates during the descent can be determined; after the process is implemented, whether the workpiece is within the focusing ring can be determined. If the workpiece deviates or shifts relative to the focusing ring, the robot arm can correct the workpiece during pick-up; as another example, the workpiece can be slid into the focusing ring by adjusting the height of the ejector pins. The controller can also determine whether the workpiece has stuck during the lifting of the ejector pins using the first projection and second projection. If the workpiece has stuck, residual charge on the electrostatic chuck can be removed, thus systematically solving the problems of sticking and displacement.

The present disclosure also provides semiconductor process equipment, including a position calibration apparatus, which includes the position calibration apparatus provided in the embodiments of the present disclosure.

This position calibration apparatus can be used to calibrate the workpiece on a first plane, and can also calibrate the robot arm and the workpiece on a second plane.

It is understood that the above embodiments are merely exemplary embodiments used to illustrate the principles of the present disclosure; however, the present disclosure is not limited thereto. For those skilled in the art, various modifications and improvements can be made without departing from the spirit and substance of the present disclosure, and these modifications and improvements are also considered to be within the scope of the present disclosure.

## Claims

1. A position calibration apparatus for use in semiconductor process equipment, comprising: a first light curtain assembly disposed within a process chamber of the semiconductor process equipment;
the first light curtain assembly includes a first light curtain emitting end, a first light curtain receiving end, a second light curtain emitting end, and a second light curtain receiving end located on a first plane;
the first light curtain emitting end is configured to emit a first calibration light onto a workpiece within the process chamber, and the first light curtain receiving end is configured to receive the first calibration light and obtain a first projection of the workpiece on the first light curtain receiving end;
the second light curtain emitting end is configured to emit a second calibration light onto the workpiece, and the second light curtain receiving end is configured to receive the second calibration light and obtain a second projection of the workpiece on the second light curtain receiving end; an angle between a projection of the first calibration light and a projection of the second calibration light on the first plane is greater than 0°;
a controller is configured to determine position information of the workpiece based on the first projection and the second projection.

2. The position calibration apparatus according to claim 1, wherein, determining the position information of the workpiece based on the first projection and the second projection includes:
determining a measured position of the workpiece on a first coordinate axis in a calibration coordinate system based on the first projection;
determining a measured position of the workpiece on a second coordinate axis in the calibration coordinate system based on the second projection;
determining the position information of the workpiece based on the measured position on the first coordinate axis and the measured position on the second coordinate axis in the calibration coordinate system.

3. The position calibration apparatus according to claim 1, wherein the position calibration apparatus further includes a second light curtain assembly, the second light curtain assembly including a third light curtain emitting end, a third light curtain receiving end, a fourth light curtain emitting end, and a fourth light curtain receiving end located on a second plane, the second plane being located above the first plane;
the third light curtain emitting end is configured to emit a third calibration light to a robot arm extending into the process chamber, the third light curtain receiving end is configured to receive the third calibration light, and obtain a third projection of the robot arm on the third light curtain receiving end;
the fourth light curtain emitting end is configured to emit a fourth calibration light to the robot arm extending into the process chamber, the fourth light curtain receiving end is configured to receive the fourth calibration light, and obtain a fourth projection of the robot arm on the fourth light curtain receiving end; an angle between a projection of the third calibration light and a projection of the fourth calibration light on the second plane is greater than 0°;
the controller is further configured to determine position information of the robot arm based on the third projection and the fourth projection.

4. The position calibration apparatus according to claim 3, wherein the position information of the robot arm includes a horizontal offset and levelness of the robot arm;
determining the position information of the robot arm based on the third projection and the fourth projection includes:
determining the horizontal offset of the robot arm based on the third projection;
determining the levelness of the robot arm based on the fourth projection.

5. The position calibration apparatus according to claim 4, wherein, determining the horizontal offset of the robot arm based on the third projection, includes:
determining a measured position of a first designated point of the robot arm based on the third projection;
determining the horizontal offset of the robot arm based on the measured position of the first designated point and a standard position corresponding to the first designated point.

6. The position calibration apparatus according to claim 4, wherein, determining the levelness of the robot arm based on the fourth projection, includes:
determining a measured position of a second designated point and a measured position of a third designated point of the robot arm based on the fourth projection;
determining position information of the second designated point based on the measured position of the second designated point of the robot arm and a standard position corresponding to the second designated point, and determining position information of the third designated point based on the third designated point and a standard position of the third designated point of the robot arm;
determining the levelness of the robot arm based on the position information of the second designated point and the position information of the third designated point.

7. The position calibration apparatus according to claim 6, wherein, the second designated point includes a first endpoint of a lower surface of the robot arm, and the third designated point includes a second endpoint of the lower surface of the robot arm; or, the second designated point includes the second endpoint of the lower surface of the robot arm, and the third designated point includes the first endpoint of the lower surface of the robot arm.

8. The position calibration apparatus according to claim 3, wherein an angle between the projection of the first calibration light and a projection of an extension/retraction direction of the robot arm onto the first plane is 30°-60°;
an angle between the projection of the second calibration light and the projection of the extension/retraction direction of the robot arm onto the first plane is 120°-150°;
an angle between the projection of the third calibration light and the projection of the extension/retraction direction of the robot arm onto the second plane is 30°-60°;
an angle between the projection of the fourth calibration light and the projection of the extension/retraction direction of the robot arm onto the second plane is 120°-150°.

9. The position calibration apparatus according to claim 3, wherein the process chamber further includes a transfer port through which the robot arm enters and exits the process chamber;
the position calibration apparatus further includes a robot arm detection component for detecting extension/retraction amount of the robot arm;
the robot arm detection component includes a first sensor and a second sensor, the first sensor and the second sensor being disposed inside the transfer port and opposite to each other, and the first sensor and the second sensor being disposed on the second plane.

10. The position calibration apparatus according to claim 9, wherein the first sensor includes a pressure sensor or a distance sensor; and the second sensor includes a pressure sensor or a distance sensor.

11. The position calibration apparatus according to claim 7, wherein the controller is further configured to:
acquire a first measured value from the first sensor and a first measured value from the second sensor during a process of the robot arm extending into the process chamber;
determine the extension/retraction amount of the robot arm based on the first measured value from the first sensor, the first measured value from the second sensor, and a horizontal offset of the robot arm;
acquire a second measured value from the first sensor and a first rotation amount of the robot arm during a rotation of the robot arm toward the first sensor;
determine an adjustment amount of the robot arm in a first direction based on the first rotation amount of the robot arm and the second measured value from the first sensor;
acquire a second measured value from the second sensor and a second rotation amount of the robot arm during the rotation of the robot arm toward the second sensor;
determine an adjustment amount of the robot arm in a second direction based on the second rotation amount of the robot arm and the second measured value from the second sensor.

12. The position calibration apparatus according to claim 3, wherein an illumination height of the first calibration light and an illumination height of the second calibration light are greater than or equal to 3 mm;
an illumination height of the third calibration light and an illumination height of the fourth calibration light are greater than or equal to 8 mm.

13. The position calibration apparatus according to claim 1, wherein the controller is further configured to:
in response to ejector pins being in a raised state, determine, based on the first projection and the second projection, whether height difference between different ejector pins is within a preset height threshold range, the ejector pins being configured to lift and place the workpiece on a carrying surface of a carrier apparatus carrying the workpiece;
in response to the height difference between the ejector pins being within the height threshold range, and a height of the workpiece is consistent with a height of the ejector pins, determine that the workpiece is normal;
in response to the height difference between the ejector pins being within the height threshold range, and the height of the workpiece is inconsistent with the height of the ejector pins, determine that the workpiece has been displaced;
in response to the height difference between the ejector pins being not within the height threshold range, determine that the workpiece is stuck.

14. Semiconductor process equipment, comprising a position calibration apparatus, wherein the position calibration apparatus includes the position calibration apparatus according to any one of claims 1 to 13.
